(19) Europäisches Patentamt
European Patent Office
Office européen des brevets

(11) EP 1 119 915 B1

(12) EUROPEAN PATENT SPECIFICATION

(45) Date of publication and mention of the grant of the patent: **04.06.2003 Bulletin 2003/23**

(21) Application number: **99953182.5**

(22) Date of filing: **12.10.1999**

(51) Int Cl.[7]: **H03M 13/29**, H03M 13/27

(86) International application number: **PCT/US99/24066**

(87) International publication number: **WO 00/022739 (20.04.2000 Gazette 2000/16)**

# (54) HYBRID INTERLEAVER FOR TURBO CODES

HYBRID VERSCHACHTELER FÜR TURBO-KODIERER

DISPOSITIF D'IMBRICATION HYBRIDE POUR TURBO-CODES

(84) Designated Contracting States:
**AT BE CH CY DE DK ES FI FR GB GR IE IT LI LU MC NL PT SE**

(30) Priority: **13.10.1998 US 104040 P**
**14.12.1998 US 112318 P**

(43) Date of publication of application: **01.08.2001 Bulletin 2001/31**

(73) Proprietor: **INTERDIGITAL TECHNOLOGY CORPORATION**
**Wilmington, DE 19801 (US)**

(72) Inventor: **SHIN, Sung-Hyuk**
**Fort Lee, NJ 07024 (US)**

(74) Representative: **Frohwitter, Bernhard, Dipl.-Ing.**
**Patent- und Rechtsanwälte,**
**Possartstrasse 20**
**81679 München (DE)**

(56) References cited:
- **W.J. BLACKERT, E.K. HALL, S.G. WILSON: "Turbo code termination and interleaver conditions" ELECTRONICS LETTERS, vol. 31, no. 24, 23 November 1995 (1995-11-23), pages 2082-2084, XP000874322**
- **DIVSALAR D ET AL: "TURBO CODES FOR PCS APPLICATIONS" PROCEEDINGS OF THE INTERNATIONAL CONFERENCE ON COMMUNICATIONS (ICC),US,NEW YORK, IEEE,1995, pages 54-59, XP000532968 ISBN: 0-7803-2487-0**
- **BARBULESCU A S ET AL: "Terminating the trellis of turbo-codes in the same state" ELECTRONICS LETTERS,GB,IEE STEVENAGE, vol. 31, no. 1, 5 January 1995 (1995-01-05), pages 22-23-23, XP002114029 ISSN: 0013-5194**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 1 119 915 B1

## Description

## BACKGROUND OF THE INVENTION

### Field of the Invention

The present invention relates generally to processes that create time diversity in systems with high processing gain. More specifically, the invention relates to a system and method of turbo code interleaving mapping where the number of tail bits required to flush the storage registers of each constituent encoder to an all-zero state are reduced.

### Description of the Prior Art

In many types of data communication systems, whether voice or non-voice, signal diversity or redundancy when transmitting information is shown to improve performance without compromising other aspects of the data transmission system. Two techniques that add time diversity are known as interleaving and forward error-correcting (FEC) coding.

The process of interleaving is where the input data sequence is permuted or reordered into another sequence. For example:

$$(0\,1\,2\,3\,4\,5\,6\,7) \xleftarrow{I_N} (3\,0\,6\,7\,1\,5\,2\,4)$$

where the mathematical operator $I_N$ *[J]* transposes the original position of each bit or symbol of a finite input sequence to a new position *J* by operation of the interleaver $I_N$. This reordering process that achieves time diversity is called interleaving and can be performed in a number of ways. Two methods of typical interleaving are known as block and random interleaving.

At the transmission destination, the signal is again reordered, putting the data sequence back in the original order. The inverse process is called deinterleaving.

The most recent advance in coding techniques which exhibit the best performance are turbo codes. A variety of turbo code interleaver designs exist and require less complexity when decoding. The three most popular are: 1) block interleavers; 2) pseudo-random interleavers; and 3) S-random interleavers.

The best performing interleavers are the S-random interleavers. The S-random interleavers exploit the property of not mapping neighbor positions within a certain sequence length, to neighbor positions exhibiting the same length. This makes the sequence length as large as possible. All interleaver designs require a specific set of rules setting forth input sequence size and permutation.

In conjunction with interleaving, FEC coding improves performance for signals that are coherently demodulated. FEC coding adds additional redundancy in the original data sequence. In communication systems that communicate over a spread spectrum air interface, redundancy is already present in the shared spectral transmission channel. An FEC encoder is a finite-state machine that relies upon nodes or states and delay registers. The predetermined transitions between the registers define a path from which a given data input may produce an output. A common way to illustrate the encoding and decoding technique for the convolutionally encoded data is the use of a trellis diagram which is known to those familiar with this art. A trellis diagram is an infinite replication of a state machine diagram and is shown in **Figure 1**.

The decoding is typically performed using a maximum likelihood algorithm which relies upon the trellis structure and the path state or metric for each level and each selected node or state. Any code word of a convolutional code corresponds to the symbols along a path in the trellis diagram. At each state and at each level of the trellis an add-compare-select operation is performed to select the best path and state. The trellis is assembled over many received symbols. After a predefined number of symbols have been accumulated, the determination finds the trellis path with the smallest error. The final decision on all bits in the trellis is made via the encoders by forcing the encoder to return to an initial all-zero state. This is achieved by inserting zero tail bits at the end of the finite bit stream after encoding. This process is referred to as "tailing off."

A process known as "chaining back" is performed starting at the last node, tracing the decision path back from the last decision to the first. This method of decoding determines which symbol was originally sent. The trellis structure introduces redundancy and accumulates past history.

A prior art turbo encoder is shown in **Figure 2**. The encoder comprises first and second systematic recursive convolutional code (RCS) encoders coupled in parallel with a turbo code interleaver coupled prior to the second recursive convolutional encoder. The two recursive convolutional codes used in each encoder are known as the constituent codes. The first encoder reorders the input information bits $\vec{x}_N$ in their original order while the second encoder reorders the input bits as permuted by the turbo code interleaver $\vec{x}^I_N$. The input information sequence $\vec{x}_N$ is always transmitted through a channel. In dependence upon the data transmission rate, the outputs from both encoders may be "punctured" before transmission $\vec{Y}_N$ Puncturing is a process where alternate outputs of the lower taps (first and second encoders $\vec{p}^1_N, \vec{p}^2_N$) are deleted from the output. This process establishes a code rate.

The turbo code interleaver is a scrambler defined by a permutation of the sequence length with no repetitions. A complete sequence is input into the interleaver and output in a predefined order.

A prior art tailing off process is shown and described in **Figures 3** and **4**. The tail bits for each encoder are obtained from register feedback from each respective encoder as shown in **Figure 3**. Since the register contents of each constituent encoder, are different at the beginning of the tailing off operation, each encoder must be flushed separately. As described in **Figure 4**, each encoder (in **Figure 3**) is flushed independently and exclusive of each other after the information bits have been encoded. Each encoder derives and receives its own tail bits. Therefore, if m equals e the number of states of register memory of an encoder, m tail bits are required for one encoder and 2m are required for both encoders.

A prior art turbo code decoder is shown in **Figure 5.** On receiving the demodulated soft value signal $\vec{y}_N$, the soft-decision information for the systematic (information) and parity bits $\vec{p}^1_N$ from the first constituent encoder are input to a first constituent decoder. The first constituent decoder generates updated, soft-decision likelihood values $\vec{L}_{e1}(\vec{x}_N)$ for the information bits that are input along with the information bits to a decoder interleaver. The input to a second constituent decoder includes the interleaved soft-valued sequences $\vec{x}^I_N$ *and* $\vec{L}^I_{e1}(\bar{x}_N)$ and the parity bits $\vec{p}^2_N$ from the second constituent encoder. The output of the second decoder improves on the soft-decision likelihood values derived from the output from the first constituent decoder and is fed back to the first constituent decoder after reordering in accordance with the turbo decoder interleaver as an iterative process. The output $\vec{x}^e$ from the second constituent decoder is obtained after the decoding operation is completed.

As discussed above, the use of a turbo code interleaver requires that coding be performed on a finite sequence length. To encode such a finite information sequence, it is necessary for both constituent RSC encoders in the turbo encoder to start and end in an all zero-state for trellis termination. However, due to the presence of the turbo interleaver, it is difficult to simultaneously force the two constituent encoders to terminate in an all zero-state with the same trellis bits. Most prior art turbo encoders have their information sequences terminated with a plurality of tail bits. Tail bits are considered a nuisance and as overhead of the turbo encoded sequence.

The difficulties with flushing turbo code encoders and bringing their trellises back to their initial state have long been recognized by the prior art. For example, the article entitled "Turbo Code Termination And Interleaver Conditions" by Blackert-et al., Electronics Letters, Vol. 31, No. 24, pp 2082 - 2084, 1995, the article entitled "Turbo Codes For PSC Applications" by Divsalar et al., IEEE Proc. Int. Conf. Comm. 1995, pp 54 - 59, and the article entitled "Terminating The Trellis Of Turbo-Codes In The Same State" by Barbulescu et al., Electronics Letters, Vol. 31, No. 1, pp 22 - 23, 1995, recognize the problems inherent in bringing the trellises of multiple encoders back to their initial states. However, none of these prior art solutions provide a suitable method for bringing the trellises of multiple encoders back to their initial state without reduction in the efficiency of the encoder.

Accordingly, there exists a need for a turbo code interleaver that does not require a plurality of tail bits to force each constituent encoder to an all-zero state.

## SUMMARY OF THE INVENTION

The present invention relates to a turbo code hybrid interleaver having recursive systematic constituent encoders. The system and process encodes a finite frame of bits without requiring a plurality of tail bits to flush the registers of each encoder to an all-zero state. The hybrid interleaver reduces the turbo code overhead by using the same tail bits for both constituent encoders improving the performance of the best turbo interleaver.

Accordingly, it is an object of the present invention to provide a system and method of interleaving that does not require a plurality tail bits to be part of the encoding process.

It is a further object of the invention to eliminate the unnecessary overhead in the turbo code encoding sequence limiting the number of tail bits that terminate the encoding process to an all-zero state with a single m-bit tail where m is the number of storage registers in each constituent encoder.

Other objects and advantages of the system and the method will become apparent to those skilled in the art after reading the detailed description of the preferred embodiment.

The present invention provides a turbo code encoder according to claim 1 and a method of encoding according to claim 7. Further preferred aspects of the invention are provided according to the dependant claims.

## BRIEF DESCRIPTION OF THE DRAWINGS

**Figure 1** is a prior art trellis diagram for a 4 state RSC encoder.
**Figure 2** is a system diagram of a prior art, turbo code encoder.
**Figure 3** is a system diagram of a prior art, four state encoder showing tailing off.
**Figure 4** is a flowchart of a prior art method of tailing off.
**Figure 5** is a system diagram of a prior art, turbo code decoder.
**Figure 6** is a system diagram of a turbo code encoder with a hybrid interleaver employing the system and method of the present invention.
**Figure 7** is a flowchart of the interleaver method embodying the present invention.
**Figure 8** is a 16 frame size interleaving sequence produced by the present invention for a 4 state turbo code encoder with S equal to 2 and L equal to 4.
**Figure 9** is the mapping of the interleaving sequence of **Figure 8.**
**Figure** 10 is the 16 frame size interleaving sequence of **Figure 8** verified.
**Figure 11** is a flowchart of the tailing off method embodying the present invention.
**Figure 12** is a flowchart of an alternative embodiment.

## DETAILED DESCRIPTION OF THE PREFERRED EMBODIMENTS

A turbo code encoder **17** with a hybrid interleaver **19** taught in accordance with the present invention as shown in **Figure 6** terminates the first **21** and second **23** RCS constituent encoders to an all-zero state using a single tailing off bit operation 25. The present invention **17** exploits the cyclic property of each constituent encoder **21**, **23** in conjunction with keeping the performance of the best turbo interleavers. The turbo code encoder **17** with hybrid interleaver **19** reduces additional tail bit overhead necessary for trellis termination of each constituent encoder **21**, **23**.

**Figures 6** and **7**, describe the system and process of the hybrid turbo code interleaver **19**. The process **51** begins (**step 53**) by receiving a sequence of input data **27** for encoding. The encoding sequence frame size *N* is chosen (**step 55**). The state size and puncturing rate (code rate) are independent of the hybrid interleaver **19.** The hybrid interleaver **19** generates the random integers I(k) for permutation **(step 57).**

As shown in **Figures 8** and **9,** the generation of the random integer sequence is performed bit by bit for each frame **29** position $31_{1\text{-}n}$. The generation of a random integer **(step 57)** denoted as *I(k)* is:

$$1 \le I(k) \le N \qquad \text{Equation (1)}$$

where $k$ = 1,2,. .,N for each mapped 33 position $35_{1\text{-}N}$ in the interleaver sequence. The current selection, *I(k)* must meet conditions *A* **(step 59)**, *B* **(step 63)** and *C* **(step 65)** as follows.

$$\textit{Condition A}: \left|I(k) - I(k-j)\right| > S \qquad \textbf{Equation (2)}$$

where

$$0 < j \le S \qquad \text{Equation (3)}$$

and

$$k - j \ge 0. \qquad \text{Equation (4)}$$

*Condition A* **Equation (2)** represents the properties of *S*-random interleavers. S is an arbitrary value.

$$\textit{Condition B}: |I(k) - I(k - n \cdot L)| \ne j \cdot L \qquad \text{(Equation (5)}$$

**(step 63)** where n and j are positive integers subject to:

$$k - n \cdot L \geq 0; \quad \text{(Equation (6))}$$

; and

$$n \cdot L \leq S \quad \text{Equation (7)}$$

**(step 61)**

*L* is determined by the constituent encoder used in the turbo code encoder. As an example, *L=7* is used in an eight state turbo encoder.

$$\textit{Condition C}: k \bmod 2^m - 1 = I(k) \bmod 2^m - 1 \; \forall \; k \quad \text{Equation (9)}$$

(**step 65**) where m is the size of memory in the constituent encoder. For 4 and 8 state encoders, m equals 2 and 3 respectively. The above steps are repeated until all of the integers, $I(k)$ for $k$=1, 2, ... ,$N$, (**step 66**) for the hybrid interleaver **19** are selected (**step 67**) and output (**step 69**).

An example of the above system and method is shown in **Figures 8**, **9** and **10**. A sequence frame size of 16 using a 4 state turbo code encoder **17** with hybrid interleaver **19** with *S* equal to 2 and *L* equal to 4 is shown permuted in accordance with the teachings of the invention. The hybrid interleaver **19** satisfies *Conditions A* and *B.* The hybrid interleaver **19** output **37** is verified in **Figure 10** using *Condition C* such that after dividing the index of an input **27** information sequence by $\mathbf{2^m - 1}$ , the resulting remainder sequence **39A** is equal to the corresponding remainder sequence **39B** due to the interleaving mapping index **33**. Once the turbo code hybrid interleaver **19** is specified **51**, the information bits **27** are permuted according the hybrid interleaver **19** in order for the second **23** constituent encoder to receive the output **37**.

The process of the present invention that terminates the trellis using the same tail bits for the first **21** and second **23** constituent encoders is shown and described in **Figures 6** and **11**. As described above, the information bits are encoded by both encoders. The first **21** constituent encoder operates on the information bits **27** in their original order. The second **23** constituent encoder operates on the information bits **27** as permuted **37** according to the hybrid interleaver **19**. The output from the first **21** and second **23** constituent encoders are punctured and multiplexed producing an output (see **Figure 2**).

The trellis termination process **81** using the same tail bits for both constituent encoders starts (**step 83**) with acknowledging that all of the information bits have been encoded by the first **21** and second **23** constituent encoders. At this time in the encoding process, the register contents of both encoders are the same. The first **21** and second **23** encoders switch inputs from the original information **27** and permuted **37** bit streams to feedback **41** from the first **21** encoder. The puncturing of the first **21** encoder output $\vec{p}1_N$ and the second **23** output $\vec{p}2_N$ with the information output $\vec{x}_N$ for the tailing off process is the same as during the encoding **21**, **23** of the information bits **27**, **37**. After both switches **43**, **45** transition, the first **21** encoder receives tail bits from its own register via the feedback **41** (**step 85**). The tail bits to the second **23** encoder have not been interleaved by the hybrid interleaver **19** and are the same tail bits **41** for trellis termination as in the first **21** encoder **(step 87).**

For a M state encoder, $\mathbf{log_2}$ M tail bits are required to flush all of the registers in the first **21** and second **23** encoders to an all-zero state. With $L$ = $\mathbf{log_2}$M, **Table 1** shows the required number of tail bits and the total number of tail coded symbols for a 4 and 8 state encoder.

TABLE 1

| | | $L$ | Total coded bits at tail part (prior art) | Total coded bits at tail part (present invention) |
|---|---|---|---|---|
| 8-state encoder | ½ rate Turbo code | 3 | 2 X 6 = 12 | 6 |
| | $^1/_3$ rate Turbo code | 3 | 2 X 9 = 18 | 9 |
| 4-state encoder | ½ rate Turbo code | 2 | 2 X 4 = 8 | 4 |
| | $^1/_3$ rate Turbo code | 2 | 2 X 6 = 12 | 6 |

For a 1/2 rate and 1/3 rate turbo code encoder with four (4) state constituent encoders, the present invention **17** eliminates 4 and 6 tail bits, respectively. For a 1/2 rate and 1/3 rate turbo code encoder with eight (8) state constituent encoders, the present invention **17** eliminates 6 and 9 tail bits, respectively, as compared to and required by the prior art.

The turbo code encoder with the hybrid interleaver yields better performance than prior art S-random interleavers since the rules stated in *Condition B* avoids worst case low weight distribution of the turbo codes while *Condition A* retains the best characteristics. Since the hybrid interleaver **19** leads to the same trellis state sequences for both the first **21** and second **23** constituent decoders at the beginning of the tail part, the use of a single m-bit tail sequence to flush both the first **21** and second **23** encoders to an all-zero state is acceptable. The extrinsic information $\vec{L}^{I}_{e1}$ including tail bits generated from the first constituent decoder are passed on to the second constituent decoder which increases to overall performance (see **Figure 5**).

As an example, if the original information sequence is

$\vec{x}_N$ = {1 011010001110101}.

The permuted information sequence according to the hybrid interleaver **19** is

$\vec{x}^{I}_{N}$= {0001011110101011}.

The information sequence is encoded by the first **21** and second **23** constituent encoders. The first **21** constituent encoder operates on the input $\vec{x}$ in its original order, while the second **23** constituent encoder operates on the permuted $\vec{x}^{I}$ interleaver **19** output.

The trellis state sequence obtained from the first **21** encoder is

{23331000021002331 0}. The trellis state sequence obtained from the second 23 encoder is

{000233333100233310}.

As shown above, the last two states (four bits) from each trellis state sequence are the same due to the hybrid interleaver **19**. This allows the first **21** and the second **23** constituent encoders to receive the same tail bits leading to reduced overhead of- the turbo coding process.

Condition C leads the trellis state of two constituent encoders to be the same after encoding information bits. This allows the same tail bits for both constituent encoders, resulting in the reduction of turbo-code overhead due to tail bits. In addition, using the same tail bits is desirable for an interative decoder as previously explained in which the interleaver design was based on a S-random interleaver. While the present invention improves turbo-code performance, its memory requirement is the same as for the S-random interleaver with the memory storage requirement proportional to the interleaver size.

An alternative embodiment is described in **Figure 12**.

Let D denote the information sequence of binary bits with block size *N* such that:

$$D = \{d_{1,}d_{2,}...,d_N\} \text{ where } d_k = \pm 1 \qquad \text{Equation (10)}$$

Given a M-state turbo-coder where M is equal to 4 or 8, we can partition the information sequence, D, into p-disjoint subsets, S, where p=M-1 as follows:

$$So = \{d_k|,k \bmod p = 0\} \qquad \text{Equation (11)}$$

$$S_1 = \{d_k \big|, k \bmod p = 1\}$$ Equation (12)

.

.

.

$$S_{p-1} = \{d_k \big|, k \bmod p = p-1\}$$

Equation (13)

where p is set to be 3 and 7 for 4-state and 8-state turbo codes, respectively. The above partition method is similar to the above coset partitioning. The value of p for each state Turbo-code is specified.

Each subset has the block size of $\lfloor N/p \rfloor$ where $\lfloor N/p \rfloor$ denotes the smallest integer value larger than or equal to *N*/*p*. Each subset is permuted by the use of any interleaver mapping. Then we combine all the individual subsets in order to obtain the entire interleaver output, denoted as *I*, as follows:

```
Count=0;
for k=1: Block _size of subset
     for i= 1: P
        if i=p
           I(count)= S0(k)
        else
           I(count)= Si(k)
        end if
        count = count + 1
        if count =N
           exit
     end
end
```

where $S_i$ (k) is the $k^{th}$ interleaved output bit of the subset $S_i$ and $S_0$ (k) is the $k^{-th}$ interleaved output bit of the subset $S_0$. The above mentioned procedures including partition and combining subsets can be re-illustrated by using a block interleaver with $\lfloor N/p \rfloor$ rows and p columns as follows:

1) The information bits are stored row-wise in the block interleaver as follows:

Write ⇒

| | | | | |
|---|---|---|---|---|
| $d_1$ | $d_2$ | $d_3$ | ..... | $d_p$ |
| $d_{p+1}$ | $d_{p+2}$ | $d_{p+3}$ | ..... | $d_{2p}$ |
| $d_{2p+1}$ | $d_{2p+2}$ | $d_{2p+3}$ | ..... | $d_{3p}$ |
| $d_{3p+1}$ | $d_{3p+2}$ | $d_{3p+3}$ | ..... | $d_{4p}$ |
| : | : | : | ..... | : |
| $d_{N/p+1}$ | $d_{N/p+2}$ | $d_{N/p+3}$ | ..... | $d_{N/p+p}$ |
| ⇑ | ⇑ | ⇑ | | ⇑ |
| $S_1$ | $S_2$ | $S_3$ | | $S_0$ |

2) Permute the bits within each column block according to the given interleaver type, which can be, in principle, one of any candidate interleavers. For example, applying conditions A and B to each column block; condition C is not necessary under these circumstances.

3) Read out the matrix row-by-row in order as shown below to drive the second constituent, whose input is the interleaved output sequence, to the same state as without interleaving the original information sequence.

Read ⇒

| | | | | |
|---|---|---|---|---|
| $d_{N/p}+1$ | $d_{N/p+2}$ | $d_{N/p+3}$ | .... | $d_{N/p+p}$ |
| $d_{3p+1}$ | $d_{3p+2}$ | $d_{3p+3}$ | .... | $d_{4p}$ |
| $d_{2p+1}$ | $d_{2p+2}$ | $d_{2p+3}$ | .... | $d_{3p}$ |
| : | : | : | .... | : |
| $d_{p+1}$ | $d_{p+2}$ | $d_{p+3}$ | .... | $d_{2p}$ |
| $d_1$ | $d_2$ | $d_3$ | .... | $d_p$ |
| ⇑ | ⇑ | ⇑ | | ⇑ |
| $S_1$ | $S_2$ | $S_3$ | | $S_0$ |

While the present invention has been described in terms of the preferred embodiment, other variations which are in the scope of the invention as outlined in the claims below will be apparent to those skilled in the art.

**Claims**

**1.** A turbo code encoder (17) for encoding at least one input set of *N* bits with permutation position integers *I(k),* where *k*= 1 to *N*, comprising:

a first encoder (21) with memory size *m*, having a first input, coupled to a first source and a common source,

and a multi-state register having $2^m$ states, for receiving said input bit set as said first source and encoding said input bit set to provide an encoded input bit set at a first output;
a hybrid S-random interleaver (19) for receiving said input bit set and reordering the bits within said input bit set to provide a reordered input bit set, where S is an arbitrary predetermined value;
a second encoder (23) with memory size m, having a second input, coupled to a second source and said common source, and a multi-state register having $2^m$ states, for receiving said reordered input bit set as said second source and encoding said reordered input bit set to provide reordered encoded input bit set at a second output; and
a switch (SW), for switching said first encoder from said first source to said common source and for switching said second encoder from said second source to said common source; whereby said first output provides said common source,

**characterized in that** said interleaver (19) reorders said integers $I(k)$ such that once reordered, the value for $|I(k) - I(k-nL)|$ is not evenly divisible by $L$, where $L = 2^m-1$, and $n$ is a positive integer defined as $k-nL \geq 0$ and $nL \leq S$.

**2.** The encoder of claim 1 further comprising a tail bit generator for generating a set of tail bits for said encoded input bit set to reset both said registers.

**3.** The encoder of claim 2 wherein said tail bit generator generates said tail bit sets using the register of said first encoder when the encoding by said first and second encoders is complete.

**4.** The encoder of claim 1 wherein said interleaver (19) randomly reorders the integers $I(k)$ for such that I (k) - $I(k-j)$ | > $S$ and $j$ is a positive integer defined as $0 < j \leq S$ and $k-j \geq 0$.

**5.** The encoder of claim 4, wherein the reordered integer I(k) sequence is verified with the following:

$$k \bmod 2^m -1 = I(k) \bmod 2^m -1.$$

**6.** The encoder of claim 1, whereby $d_k$ is an input bit of said set of $N$ bits and where $d_k = \pm 1$, said interleaver further comprising:

means for arranging said input bit sets for an $M$ state turbo code encoder into $p$ disjoint subsets $S_i$ of size $b$, where $p = M-1$, $i$ is an integer from 0 to $(p-1)$, and $b$ is the smallest integer value larger than or equal to $N/p$, where $S_i = \{d_k|, k \bmod p=i\}$ ;
means for combining subsets $S_i$, to form a block of $b$ rows and $p$ columns where $k$ is an integer from 1 to $b$ such that each element of a subset is in the same column;
means for reordering the set of input bits within said columns; and
means for outputting said rows after said column reordering to produce an interleaver reordered input bit set.

**7.** A method of encoding at least one input bit set of $N$ ordered bits with permutation position integers $I(k)$, where $k$= 1 to $N$ comprising the steps of:

a. encoding said input bit set using a first encoder (21) having a multi -state register having $2^m$ states to provide a first output;
b. selectively reordering the input bit set using a hybrid S-random interleaver (19) to provide a reordered input bit set, whereby said interleaver (19) reorders said integers $I(k)$ such that once reordered, the value for $|I(k) - I(k-nL)|$ is not evenly divisible by $L$, where $L = 2^m-1$, $n$ is a positive integer defined as $k-nL \geq 0$ and $nL \leq S$, and $S$ is an arbitrary predetermined value; and
c. encoding said reordered input bit set using a second encoder (23) having a multi -state register having $2^m$ states to provide a second output; and
d. switching said first encoder (21) from a first source to a common source and switching said second encoder (23) from a second source to said common source whereby said first output provides said common source

**8.** The method of turbo encoding of claim 7, further comprising the steps of:

generating a set of tail bits for each said input bit set; and
applying said tail bit set to reset the registers of both said first and second encoders.

**9.** The method of turbo encoding according to claim 7 wherein said selective reordering comprises the steps of:

a) receiving a plurality of $N$ information bits where $N$ is a positive integer;
b) defining the hybrid interleaver frame size $N$;
c) generating random integers $I(k)$ for $k$ from l to $N$ that satisfy the conditions:

1) $|I(k) - I(k-j)| > S$, where $S$ is a predetermined arbitrary value and $j$ is a positive integer defined as $0<j\leq S$ and $k-j \geq 0$ ;
2) $nL \leq S$, where $L$ equals number of encoder register states minus 1, and $n$ is a positive integer defined by $k - nL \geq 0$, where if not true, proceed to step 4;
3) $|I(k) - I(k-nL)| \neq jL$ where if not true, repeat steps 1-3, otherwise proceed to-step 4;
4) for each random integer $I(k)$, $k \bmod 2^m -1 = I(k) \bmod 2^m-1$, where $2^m$ is the number of register states of one of said encoders, if not true, repeat steps 1-4 ; and

d) outputting permuted interleaver data sequence for encoding.

**10.** The method of claim 8 further comprising the steps of :

a) acknowledging that encoding by said first and second encoder is complete;
b) switching inputs to said first and second encoder from an information bit stream and a permuted bit stream respectively to common feedback from said first constituent encoder last stage; and
c) incrementing the number of tail bits received from said feedback until said number of tail bits are greater than the number of registers used in said first constituent encoder, if not, repeat steps b - c.

**11.** The method of claim 7, whereby $d_k$ is an input bit of said set of N bits and $d_k=\pm 1$, said selective reordering further comprising the steps of:

arranging said input bit sets for an M state turbo code encoder into $p$ disjoint subsets $S_i$ of size $b$, where $p= M-1$, $i$ is an integer from 0 to $p-1$, and $b$ is the smallest integer value larger than or equal to $N/p$, where $S_i = \{d_k|, k \bmod p=i\}$;
combining subsets $S_i$, to form a block of $b$ rows and $p$ columns where $k$ is an integer from 1 to $b$ such that each element of a subset is in the same column;
reordering the subset elements within each column; and
outputting said rows after said column reordering to produce an interleaver reordered input bit set.

## Patentansprüche

**1.** Turbo-Code-Codierer (17) zum Codieren mindestens einer Eingabemenge von $N$ Bits mit Permutations-Positions-Ganzzahlen $I(k)$, wobei $k = 1$ bis $N$ ist, umfassend:

- einen ersten Codierer (21) mit einer Speichergröße $m$, mit einem ersten Eingang, der an eine erste Quelle und eine gemeinsame Quelle angeschlossen ist, und einem Mehrzustands-Register mit $2^m$ Zuständen zum Empfangen der Eingangsbitmenge als die erste Quelle und zum Codieren der Eingabebitmenge zum Bereitstellen einer codierten Eingabebitmenge an einem ersten Ausgang;
- einen Hybrid-S-Zufalls-Interleaver (19) zum Empfangen der Eingabebitmenge und Umordnen der Bits innerhalb der Eingabebitmenge zum Bereitstellen einer umgeordneten Eingabebitmenge, wobei S ein zufälliger vorbestimmter Wert ist;
- einen zweiten Codierer (23) mit einer Speichergröße $m$, mit einem zweiten Eingang, der an eine zweite Quelle und die gemeinsame Quelle angeschlossen ist, und einem Mehrzustands-Register mit $2^m$ Zuständen zum Empfangen der umgeordneten Eingangsbitmenge als die zweite Quelle und zum Codieren der umgeordneten Eingabebitmenge zum Bereitstellen einer umgeordneten codierten Eingabebitmenge an einem zweiten Ausgang; und
- einen Schalter (SW) zum Umschalten des ersten Codierers von der ersten Quelle auf die gemeinsame Quelle und zum Umschalten des zweiten Codierers von der zweiten Quelle auf die gemeinsame Quelle; wobei der erste Ausgang die gemeinsame Quelle bereitstellt,

**dadurch gekennzeichnet, dass** der Interleaver (19) die Ganzzahlen $I(k)$ so umordnet, dass nach der Umordnung

der Wert für $|I(k) — |(k-nL)|$ nicht glatt durch $L$ teilbar ist, wobei $L = 2^m-1$ und $n$ eine positive Ganzzahl ist, die als $k-nL \geq 0$ und $nL \leq$ S definiert ist.

**2.** Codierer nach Anspruch 1, weiter umfassend einen Endbit-Generator zum Erzeugen einer Menge von Endbits für die codierte Eingabebitmenge zum Rücksetzen der beiden Register.

**3.** Codierer nach Anspruch 2, bei dem der Endbitgenerator die Endbitmengen unter der Verwendung des Registers des ersten Codierers erzeugt, wenn das Codieren durch den ersten und durch den zweiten Codierer abgeschlossen ist.

**4.** Codierer nach Anspruch 1, bei dem der Interleaver (19) die Ganzzahlen $I(k)$ so umordnet, dass $|I(k) — I(k-j)| > S$ und $j$ eine positive Ganzzahl ist, die als $0 < j \leq S$ und $k — j \geq 0$ definiert ist.

**5.** Codierer nach Anspruch 4, bei dem die umgeordnete Ganzahl-I(k)-Sequenz durch das Folgende überprüft wird:

$$k \bmod 2^m — 1 = I(k) \bmod 2^m — 1.$$

**6.** Codierer nach Anspruch 1, bei dem $d_k$ ein Eingabebit der Menge von $N$ Bits ist und bei dem $d_k = \pm 1$, wobei der Interleaver weiter umfasst:

- Mittel zum Ordnen der Eingabebitmengen für einen $M$-Zustands-Turbo-Code-Codierer in $p$ disjunkte Teilmengen $S_i$ einer Größe $b$, wobei $p = M-1$, $i$ eine Ganzzahl aus $0$ bis $(p-1)$ und $b$ der kleinste Ganzzahlenwert ist, der größer oder gleich $N/p$ ist, wobei $S_i = \{d_k|, k \bmod p=i\}$ ist;
- Mittel zum Kombinieren von Teilmengen $S_i$ zum Bilden eines Blocks von $b$ Zeilen und $p$ Spalten, wobei $k$ eine Ganzzahl aus 1 bis $b$ ist, so dass jedes Element einer Teilmenge in der gleichen Spalte ist;
- Mittel zum Umordnen der Menge von Eingabebits innerhalb der Spalten; und
- Mittel zum Ausgeben der Zeilen nach der Spaltenumordnung zum Erzeugen einer durch den Interleaver umgeordneten Eingabebitmenge.

**7.** Verfahren zum Codieren mindestens einer Eingabebitmenge von $N$ geordneten Bits mit Permutations-Positions-Ganzzahlen $I(k)$, wobei $k = 1$ bis $N$ ist, mit den folgenden Schritten:

a) Codieren der Eingabebitmenge unter Verwendung eines ersten Codierers (21) mit einem Mehrzustands-Register mit $2^m$ Zuständen zum Liefern eines ersten Ausgangssignals;
b) selektives Umordnen der Eingabebitmenge unter Verwendung eines Hybrid-S-Zufalls-Interleavers (19) zum Liefem einer umgeordneten Eingabebitmenge, wobei der Interleaver (19) die Ganzzahlen $I(k)$ so umordnet, dass nach der Umordnung der Wert für $|I(k) - I(k-nL)|$ nicht glatt durch $L$ teilbar ist, wobei $L = 2^m-1$ und $n$ eine positive Ganzzahl ist, die als $k-nL \geq 0$ und $nL \leq S$ definiert ist und $S$ ein zufälliger vorbestimmter Wert ist; und
c) Codieren der umgeordneten Eingabebitmenge unter Verwendung eines zweiten Codierers (23) mit einem Mehrzustands-Register mit $2^m$ Zuständen zum Liefern eines zweiten Ausgangssignals; und
d) Umschalten des ersten Codieres (21) von einer ersten Quelle auf eine gemeinsame Quelle und Umschalten des zweiten Codierers (23) von einer zweiten Quelle auf die gemeinsame Quelle, wodurch das erste Ausgangssignal die gemeinsame Quelle liefert.

**8.** Verfahren zur Turbo-Codierung nach Anspruch 7, weiter mit den folgenden Schritten:

- Erzeugen einer Menge von Endbits für jede der Eingabebitmengen; und
- Anwenden der Endbitmenge zum Rücksetzen der Register sowohl des ersten als auch des zweiten Codierers.

**9.** Verfahren zur Turbo-Codierung nach Anspruch 7, bei dem das selektive Umordnen die folgenden Schritte aufweist:

a) Empfangen einer Vielzahl von $N$ Informationsbits, wobei $N$ eine positive Ganzzahl ist;
b) Definieren der Hybrid-Interleaver-Rahmengröße $N$;
c) Erzeugen von Zufallsganzzahlen $I(k)$ für $k$ aus 1 bis $N$, die die folgenden Bedingungen erfüllen:

1) $|I(k) — I(k-j)| > S$, wobei $S$ ein vorbestimmter zufälliger Wert und j eine positive Ganzzahl ist, die als $0 < j \leq S$ und $k — j \geq 0$ definiert ist;

2) $nL \leq S$, wobei $L$ gleich der Anzahl Codierer-Registerzustände minus 1 und n eine positive Ganzzahl ist, die durch $k- nL \geq 0$ definiert ist, wobei zu Schritt 4 weiter gegangen werden soll, wenn die Bedingung nicht zutrifft;
3) $|I(k) - I(k-nL)| \neq jL$, wobei die Schritte 1-3 zu wiederholen sind, wenn diese Bedingung nicht zutrifft, ansonsten soll zu Schritt 4 weiter gegangen werden;
4) für jede Zufallsganzzahl $I(k)$, $k \bmod 2^m - 1 = I(k) \bmod 2^m - 1$, wobei $2^m$ die Anzahl von Registerzuständen eines der Codierers ist, wobei die Schritte 1-4 wiederholt werden sollen, wenn diese Bedingung nicht zutrifft; und

d) Ausgeben einer permutierten Interleaver-Datensequenz zum Codieren.

**10.** Verfahren nach Anspruch 8, weiter mit den folgenden Schritten:

a) Bestätigen, dass die Codierung durch den ersten und den zweiten Codierer abgeschlossen ist;
b) Umschalten der Eingangssignale an den ersten und zweiten Codierer von einem Informationsbitstrom bzw. einem permutierten Bitstrom auf eine gemeinsame Rückkopplung aus der letzten Stufe des ersten ein Element bildenden Codierers; und
c) Inkrementieren der Anzahl von Endbits, die aus der Rückkopplung empfangen wurden, bis die Anzahl von Endbits größer als die Anzahl von Registern ist, die im ersten ein Element bildenden Codierer verwendet wurden, wobei die Schritte b - c zu wiederholen sind, wenn dies nicht zutrifft.

**11.** Verfahren nach Anspruch 7, wobei $d_k$ ein Eingabebit der Menge von $N$ Bits und $d_k = \pm 1$ ist, wobei das selektive Umordnen weiter die folgenden Schritte aufweist:

- Ordnen der Eingabebitmengen für einen $M$-Zustands-Turbo-Code-Codierer in $p$ disjunkte Teilmengen $S_i$ einer Größe $b$, wobei $p = M - 1$, $i$ eine Ganzzahl aus 0 bis $p-1$ und $b$ der kleinste Ganzzahlwert ist, der größer oder gleich $N/p$ ist, wobei $S_i = \{d_k|, k \bmod p=i\}$ ist;
- Kombinieren der Teilmengen $S_i$ zum Bilden eines Blocks von $b$ Zeilen und $p$ Spalten, wobei $k$ eine Ganzzahl aus 1 bis $b$ ist, so dass jedes Element einer Teilmenge in der gleichen Spalte ist;
- Umordnen der Teilmengenelemente innerhalb jeder Spalte; und
- Ausgeben der Zeilen nach der Spaltenumordnung zum Erzeugen einer durch den Interleaver umgeordneten Eingabebitmenge.

## Revendications

**1.** Codeur à turbo-code (17) pour coder au moins un ensemble d'entrée de N bits avec des nombres entiers de positions de permutation I(k) , avec k = 1 à N, comprenant :

un premier codeur (21) ayant une taille de mémoire m, possédant une première entrée, couplée à une première source et à une source commune, et un registre à états multiples comportant $2^m$ états, pour recevoir ledit ensemble de bits d'entrée en tant que ladite première source et coder ledit ensemble de bits d'entrée pour délivrer un ensemble de bits d'entrée codés sur une première sortie;
un dispositif d'imbrication hybride S-aléatoire (19) pour recevoir ledit ensemble de bits d'entrée et réordonner les bits dans ledit ensemble de bits d'entrée pour fournir un ensemble de bits d'entrée réordonnés, S étant une valeur prédéterminée arbitraire;
un second codeur (23) comportant une taille de mémoire m, possédant une seconde entrée, couplée à une seconde source et à ladite source commune, et un registre à états multiples comportant $2^m$ états, pour recevoir ledit ensemble de bits d'entrée réordonnés en tant que ladite première source et coder ledit ensemble de bits d'entrée réordonnés pour produire un ensemble de bits d'entrée codés réordonnés en tant que second signal de sortie; et
un commutateur (SW) pour commuter ledit premier codeur depuis la dite première source sur ladite source commune et pour commuter ledit second codeur depuis ladite seconde source sur ladite source commune; ladite première sortie fournissant ladite source commune,

**caractérisé en ce que** ledit dispositif d'imbrication (19) réordonne lesdits nombres entiers I(k) de telle sorte qu'une fois réordonnés, la valeur pour |I(k) - I(k-nL) | n'est pas divisible exactement par L, avec $L = 2^m-1$, et n étant un entier positif défini par k-nL > 0 et nL < S.

**2.** Codeur selon la revendication 1, comprenant en outre un générateur de bits de queue pour produire un ensemble de bits de queue pour ledit ensemble de bits d'entrée codés pour ramener à l'état initial lesdits deux registres.

**3.** Codeur selon la revendication 2, dans lequel ledit générateur de bits de queue produit lesdits ensembles de bits de queue en utilisant le registre dudit premier codeur lorsque le codage effectué par lesdits premier et second codeurs est achevé.

**4.** Codeur selon la revendication 1, dans lequel ledit dispositif d'imbrication (19) réordonne de façon aléatoire les nombres entiers I(k) de telle sorte que l'on a |Ik- (Ik-j)| > S et j est un entier positif défini par 0 < j < S et k-j > 0.

**5.** Codeur selon la revendication 4, dans lequel la séquence de nombres entiers I(k) réordonnés est vérifiée avec ce qui suit :

$$k \bmod 2^m -1 = I(k) \bmod 2^m -1.$$

**6.** Codeur selon la revendication 1, dans lequel $d_k$ est un bit d'entrée dudit ensemble de N bits et on a $d_k$ = +1, ledit dispositif d'imbrication comprenant :

des moyens pour arranger lesdits ensembles de bits d'entrée pour un codeur de turbo-code à M états selon p sous-ensembles disjoints $S_i$ de taille b, avec p = M-1, i étant un entier compris entre 0 et (p-1) et b étant la valeur entière la plus petite supérieure ou égale à N/p, avec $S_i = \{d_k|$, k mod p=i};
des moyens pour combiner des sous-ensembles $S_i$ pour former un bloc de b lignes et de p colonnes, k étant un entier compris entre 1 et b de telle sorte que chaque élément d'un sous-ensemble est situé dans la même colonne;
des moyens pour réordonner l'ensemble de bits d'entrée dans lesdites colonnes; et
des moyens pour délivrer lesdites lignes après ledit réordonnancement des colonnes pour produire un ensemble de bits d'entrée réordonnés du dispositif d'imbrication.

**7.** Procédé pour coder au moins un ensemble de bits d'entrée de N bits ordonnées avec des nombres entiers de positions de permutation I(k), avec k = = 1 à N, comprenant les étapes consistant à :

a. coder ledit ensemble de bits d'entrée en utilisant un premier codeur (21) comportant un registre à états multiples comprenant $2^m$ états pour fournir un premier signal de sortie;
b. réordonner sélectivement l'ensemble de bits d'entrée en utilisant un dispositif d'imbrication hybride S-aléatoire (19) pour fournir un ensemble de bits d'entrée réordonnés, ledit dispositif d'imbrication (19) réordonne lesdits nombres entiers I(k) de telle sorte qu'une fois réordonnés, la valeur pour | I (k) - I(k-nL)| n'est pas exactement divisible par L, avec $L = 2^m-1$, n étant un entier positif défini par k-nL > 0 et nL < S, et S étant une valeur prédéterminée quelconque; et
c. coder ledit ensemble de bits d'entrée réordonnés en utilisant un second codeur (23) possédant un registre à états multiples comportant $2^m$ états pour fournir un second signal de sortie; et
d. commuter ledit premier codeur (21) depuis une première source sur une source commune et commuter ledit second codeur (23) depuis une seconde source sur ladite source commune, ladite première sortie fournissant ladite source commune.

**8.** Procédé de turbo-codage selon la revendication 7, comprenant en outre les étapes consistant à :

produire un ensemble de bits de queue pour chacun desdits ensembles de bits d'entrée; et
appliquer ledit ensemble de bits de queue pour ramener à l'état initial les registres desdits premier et second codeurs.

**9.** Procédé de turbo-codage selon la revendication 7, selon lequel ledit réordonnancement sélectif comprend les étapes consistant à :

a) recevoir une pluralité de N bits d'informations, N étant un entier positif;
b) définir la taille N de trame du dispositif d'imbrication hybride;
c) produire des nombres entiers aléatoires I(k) pour k allant de 1 à N, qui satisfont aux conditions :

1) |I(k) - I(k-j)|> S, S étant une valeur arbitraire prédéterminée et j un entier positif défini par $0<j<S$ et $k-j>0$;
2) nL $<$ S, L étant égal au nombre d'états de registres des codeurs moins 1, et n étant un entier positif défini par k - nL $>$ 0, et si cela n'est pas vrai, passer à l'étape 4;
3) |I(k) - I(k-nL)|Þ jL et si cela n'est pas vrai, répéter les étapes 1 à 3, sinon passer à l'étape 4;
4) pour chaque entier aléatoire I(k), k mod $2^m$ -1 = I(k)mod $2^m$-1, $2^m$ étant un nombre d'états de registre de l'un desdits décodeurs, et si cela n'est pas vrai, répéter les étapes 1 à 4; et

d) délivrer une séquence de données de dispositif d'imbrication permutées pour le codage.

**10.** Procédé selon la revendication 8, comprenant en outre les étapes consistant à :

a) accuser réception du fait que le codage par lesdits premier et second codeurs est terminé;
b) commuter des entrées sur lesdits premier et second codeurs depuis un flux de bits d'informations et un flux de bits permutés respectivement pour réaliser une rétroaction commune à partir dudit dernier étage du premier codeur constitutif; et
c) incrémenter le nombre de bits de queue reçus depuis ladite rétroaction jusqu'à ce que ledit nombre de bits de queue soit supérieur au nombre de registres utilisés dans ledit premier codeur constitutif, sinon répéter les étapes b-c.

**11.** Procédé selon la revendication 7, dans lequel $d_k$ est un bit d'entrée dudit ensemble de N bits et on a $d_k$ = +1, ledit réordonnancement sélectif comprenant en outre les étapes consistant à :

disposer lesdits ensembles de bits d'entrée pour un codeur à turbo-code à M états en p sous-ensembles disjoints $S_i$ d'une taille b, avec p= M-1, i étant un entier entre 0 et p-1, et b étant la valeur entière la plus petite supérieure ou égale à N/p, avec $S_i$ = {$d_k$|, k mod p=i};
combiner les sous-ensembles $S_i$ pour former un bloc de b lignes et p colonnes, k étant un entier entre 1 et b de telle sorte que chaque élément d'un sous-ensemble est dans la même colonne;
réordonner les éléments des sous-ensembles, dans chaque colonne; et
délivrer lesdites lignes après ledit réordonnancement des colonnes pour produire un ensemble de bits d'entrée réordonnés du dispositif d'imbrication.

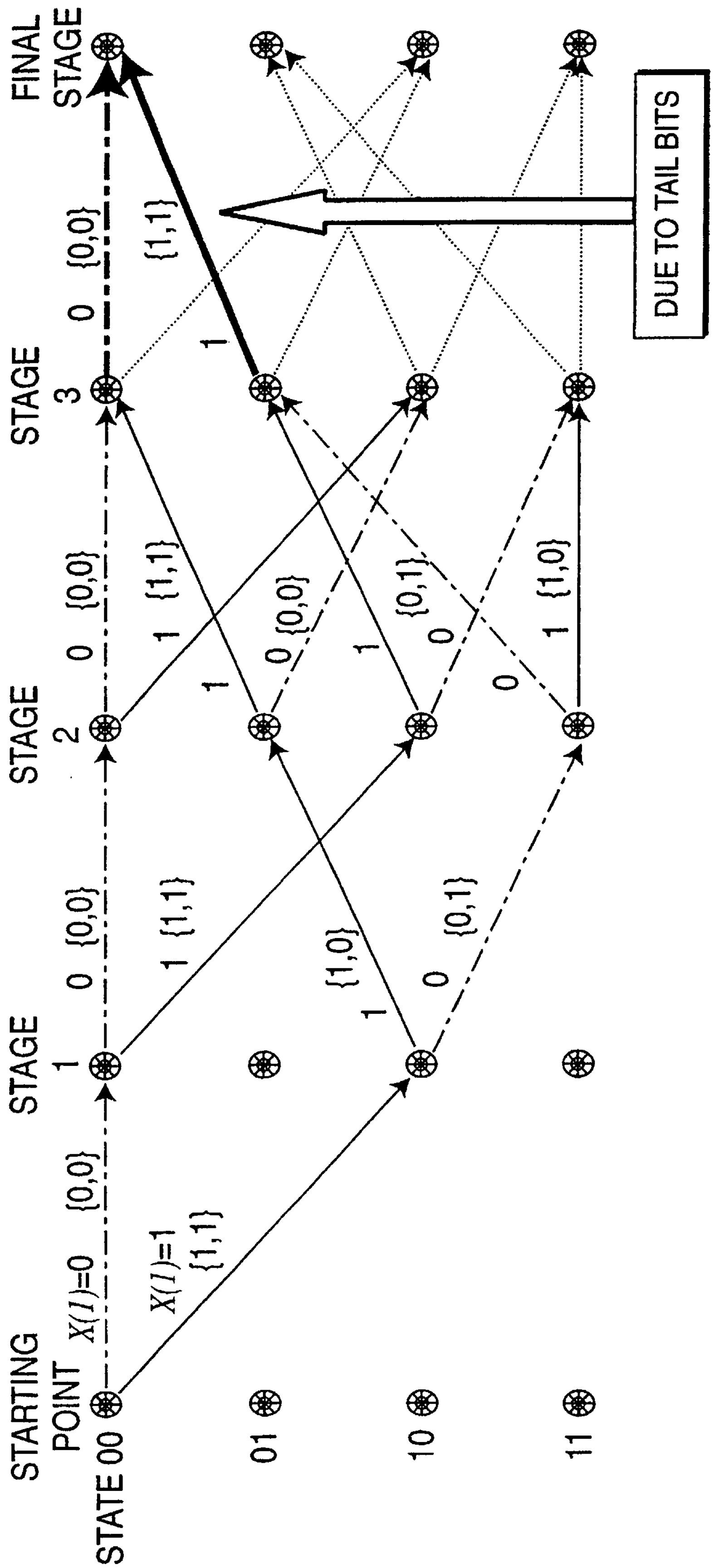


**FIG. 1**
**PRIOR ART**

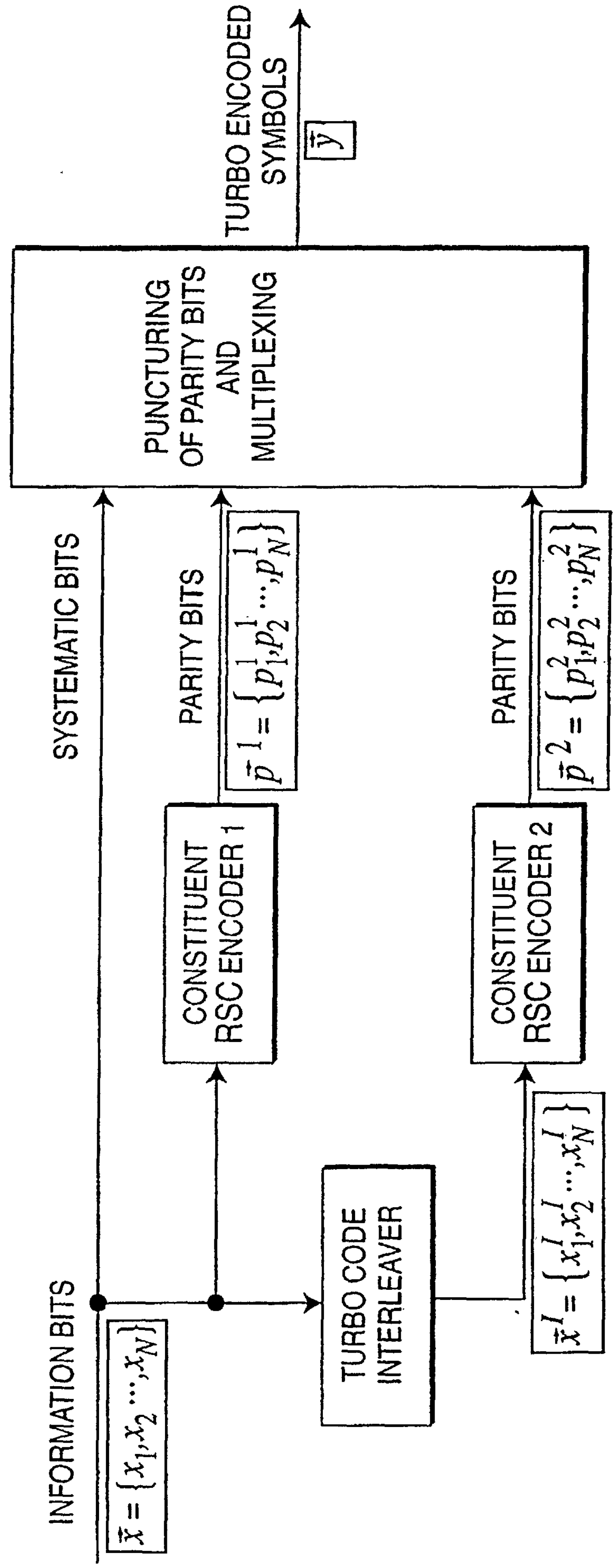


*FIG. 2*
**PRIOR ART**

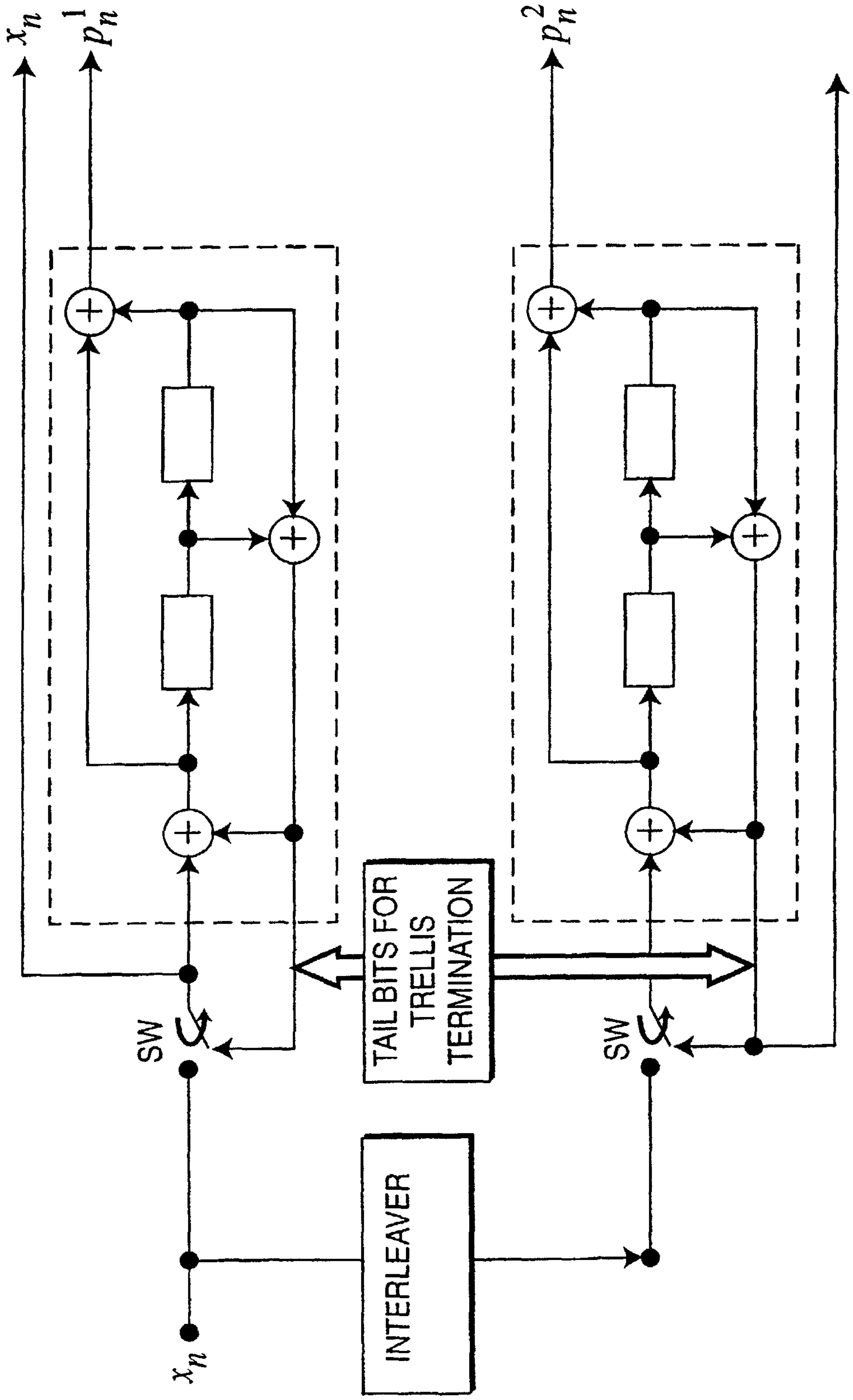


*FIG. 3*
**PRIOR ART**

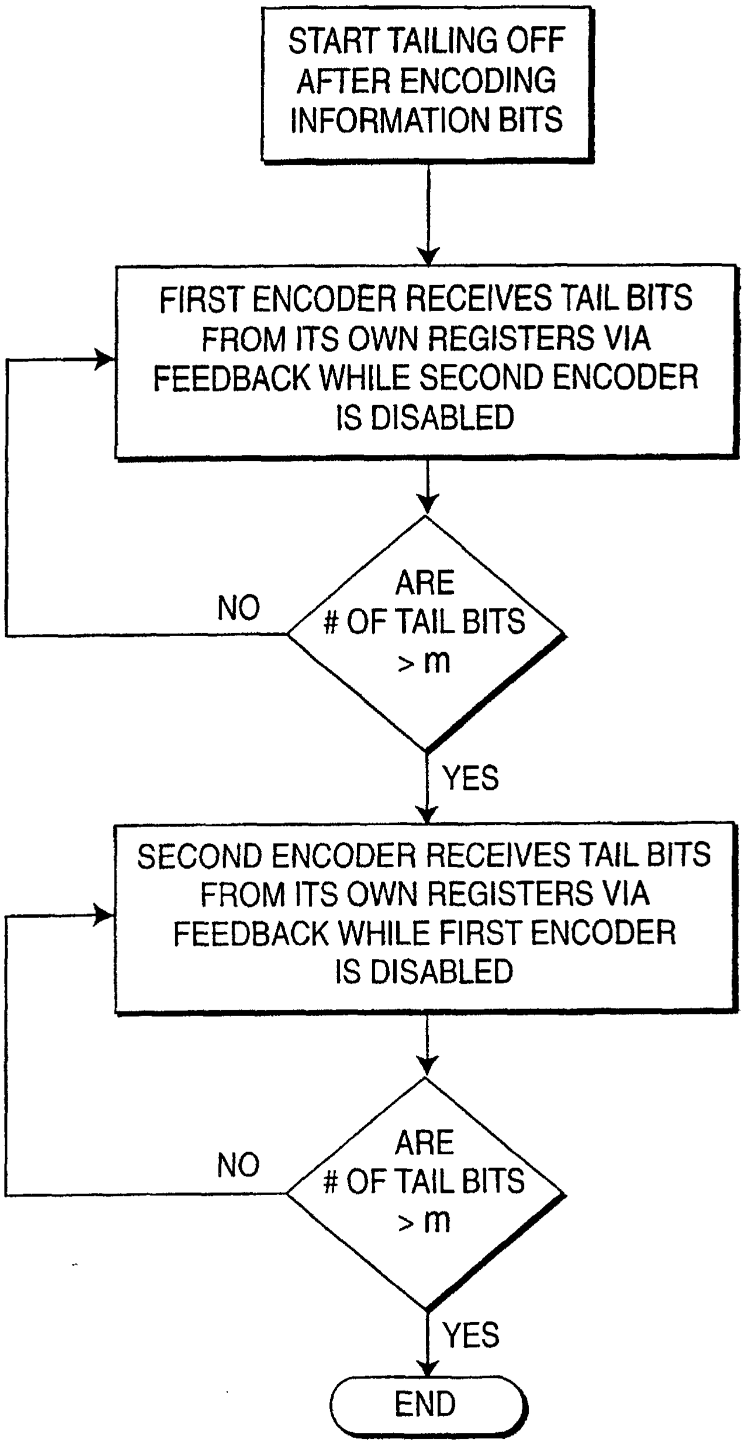


TOTAL # OF TAIL BITS = 2 m

TOTAL # OF TAIL CODED SYMBOLS = (2)(2 m)

*FIG. 4*

**PRIOR ART**

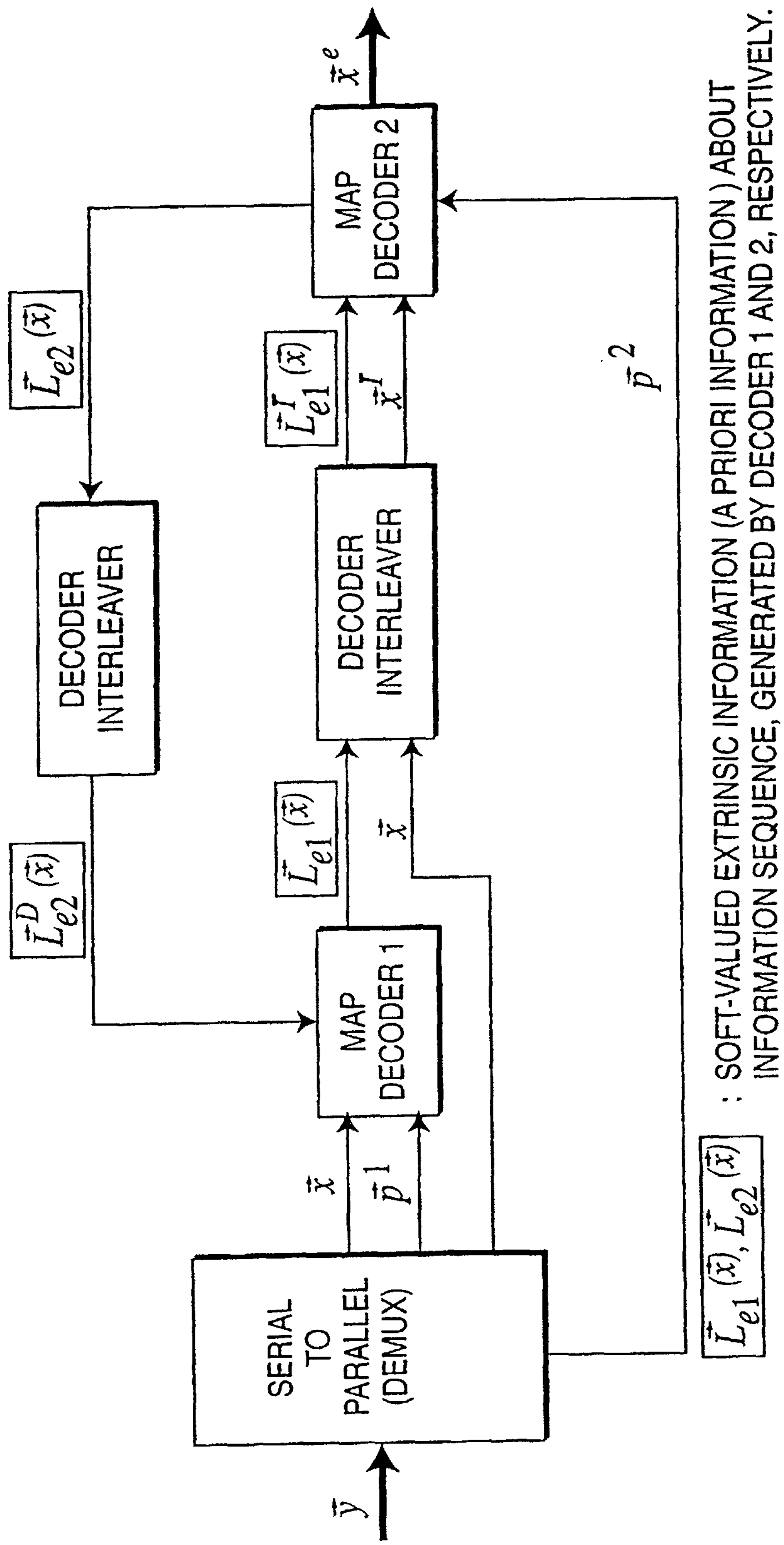


FIG. 5
PRIOR ART

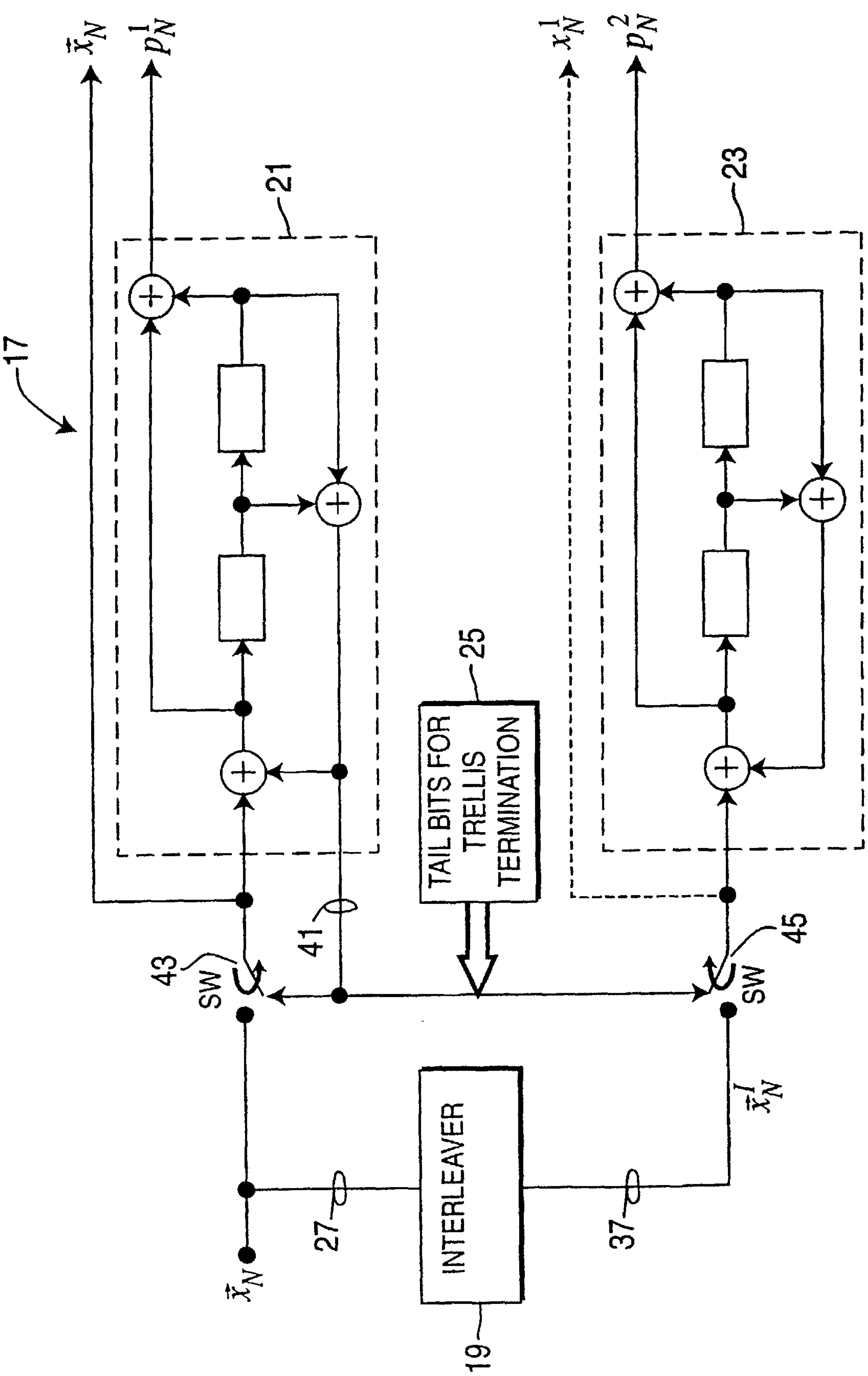
17
21
23
25
TAIL BITS FOR TRELLIS TERMINATION
INTERLEAVER
19
27
37
41
43
45
SW
SW
$\vec{x}_N$
$p_N^1$
$x_N^1$
$p_N^2$
$\vec{x}_N$
$\vec{x}_N^I$

FIG. 6

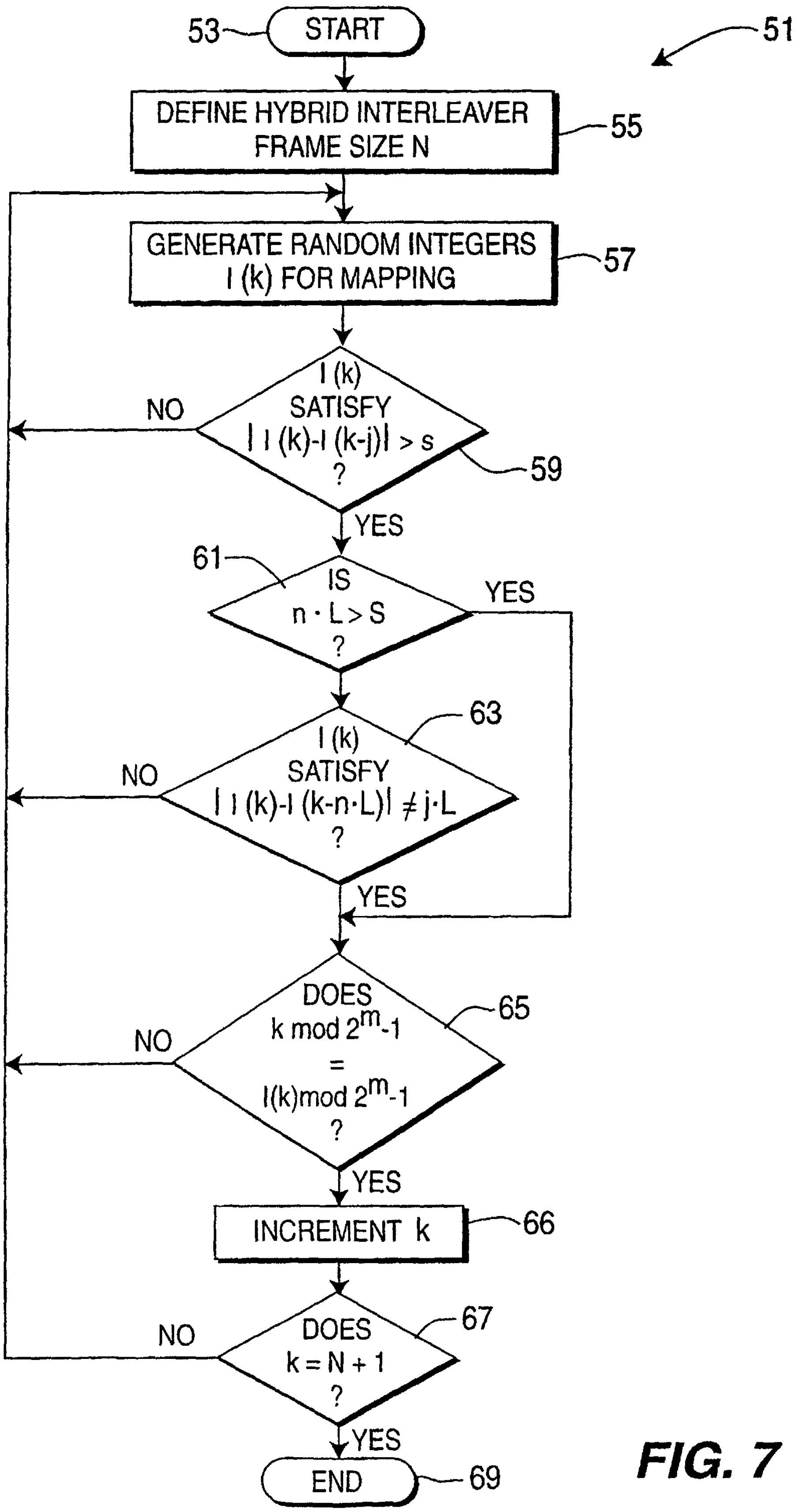
51
53
START
DEFINE HYBRID INTERLEAVER FRAME SIZE N
55
GENERATE RANDOM INTEGERS I (k) FOR MAPPING
57
I (k) SATISFY |I (k)-I (k-j)| > s ?
59
NO
YES
61
IS n · L > S ?
YES
63
I (k) SATISFY |I (k)-I (k-n·L)| ≠ j·L ?
NO
YES
DOES k mod 2^m-1 = I(k)mod 2^m-1 ?
65
NO
YES
INCREMENT k
66
DOES k = N + 1 ?
67
NO
YES
END
69

FIG. 7

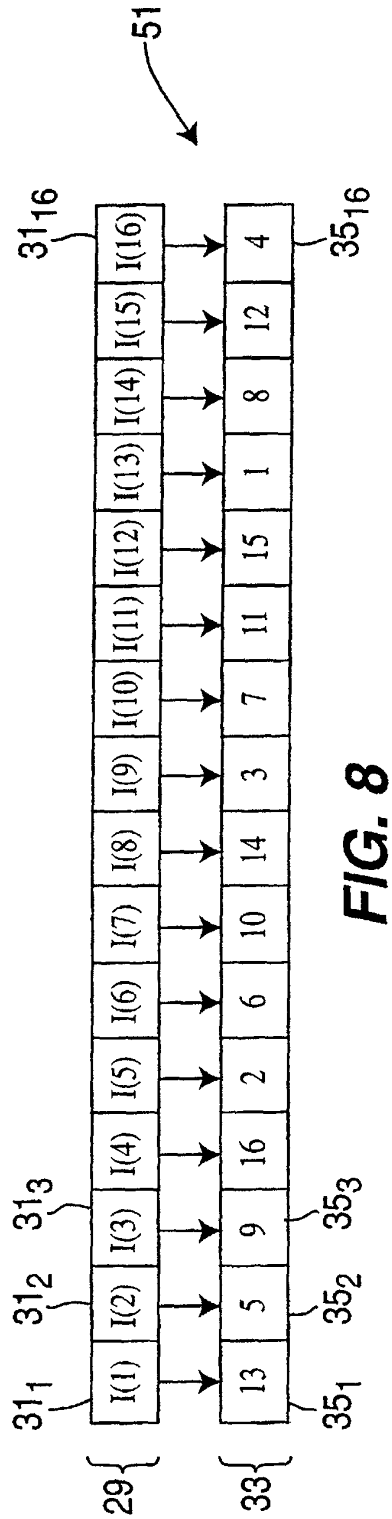
51
29
33
$31_1$
$31_2$
$31_3$
$31_{16}$
I(1) I(2) I(3) I(4) I(5) I(6) I(7) I(8) I(9) I(10) I(11) I(12) I(13) I(14) I(15) I(16)
13 5 9 16 2 6 10 14 3 7 11 15 1 8 12 4
$35_1$
$35_2$
$35_3$
$35_{16}$

FIG. 8

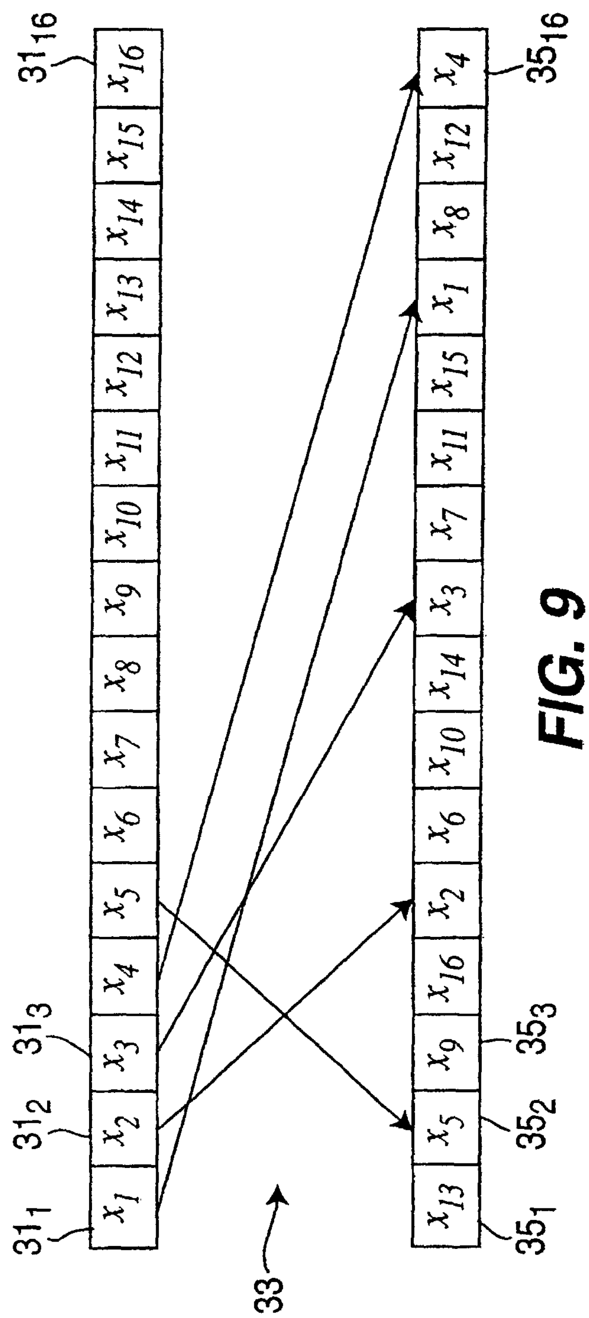
33
$31_1$
$31_2$
$31_3$
$31_{16}$
$x_1$ $x_2$ $x_3$ $x_4$ $x_5$ $x_6$ $x_7$ $x_8$ $x_9$ $x_{10}$ $x_{11}$ $x_{12}$ $x_{13}$ $x_{14}$ $x_{15}$ $x_{16}$
$x_{13}$ $x_5$ $x_9$ $x_{16}$ $x_2$ $x_6$ $x_{10}$ $x_{14}$ $x_3$ $x_7$ $x_{11}$ $x_{15}$ $x_1$ $x_8$ $x_{12}$ $x_4$
$35_1$
$35_2$
$35_3$
$35_{16}$

FIG. 9

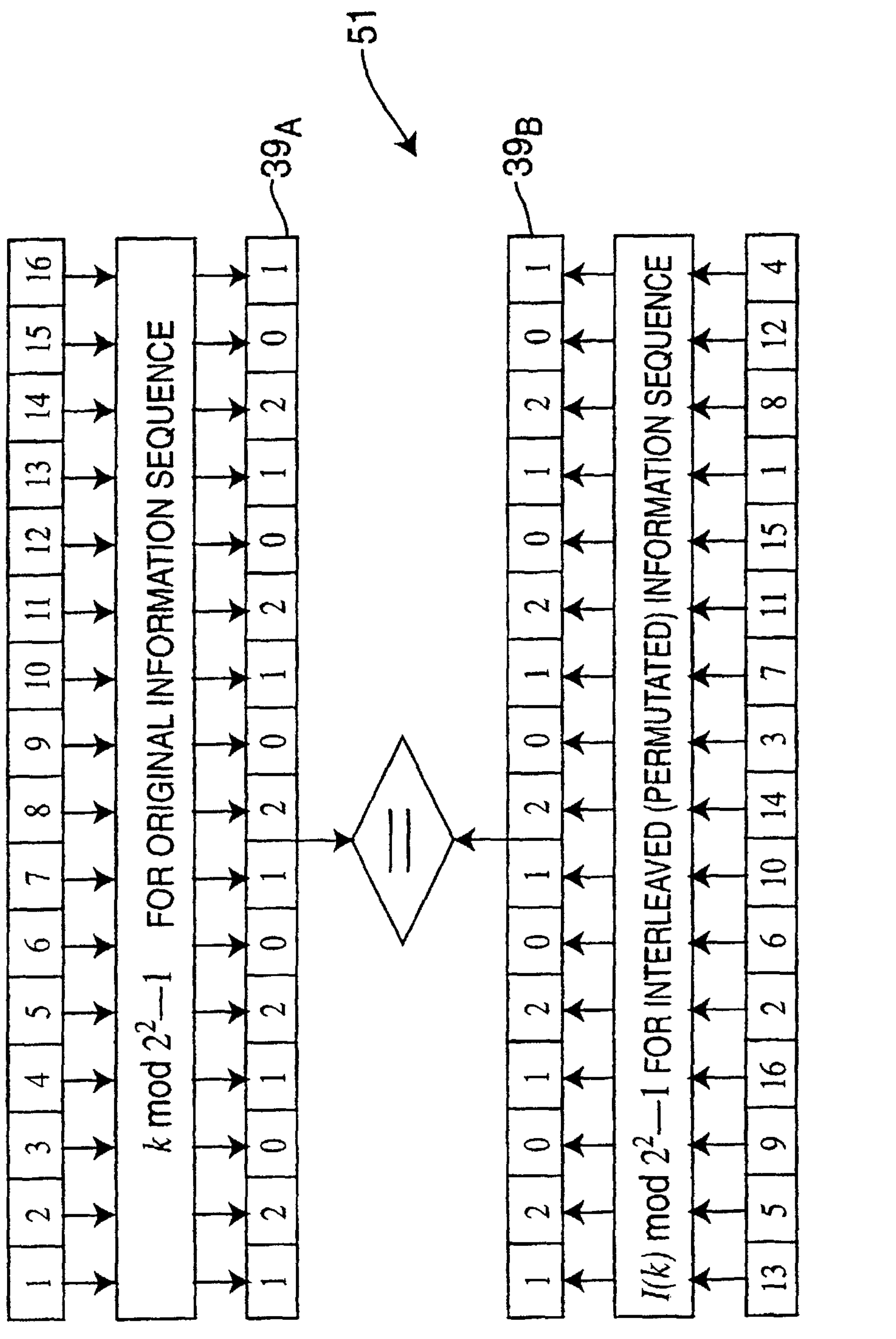
51
$39_A$
$39_B$
k mod 2²—1 FOR ORIGINAL INFORMATION SEQUENCE
I(k) mod 2²—1 FOR INTERLEAVED (PERMUTATED) INFORMATION SEQUENCE
=
1 2 3 4 5 6 7 8 9 10 11 12 13 14 15 16
1 2 0 1 2 0 1 2 0 1 2 0 1 2 0 1
1 2 0 1 2 0 1 2 0 1 2 0 1 2 0 1
13 5 9 16 2 6 10 14 3 7 11 15 1 8 12 4

FIG. 10

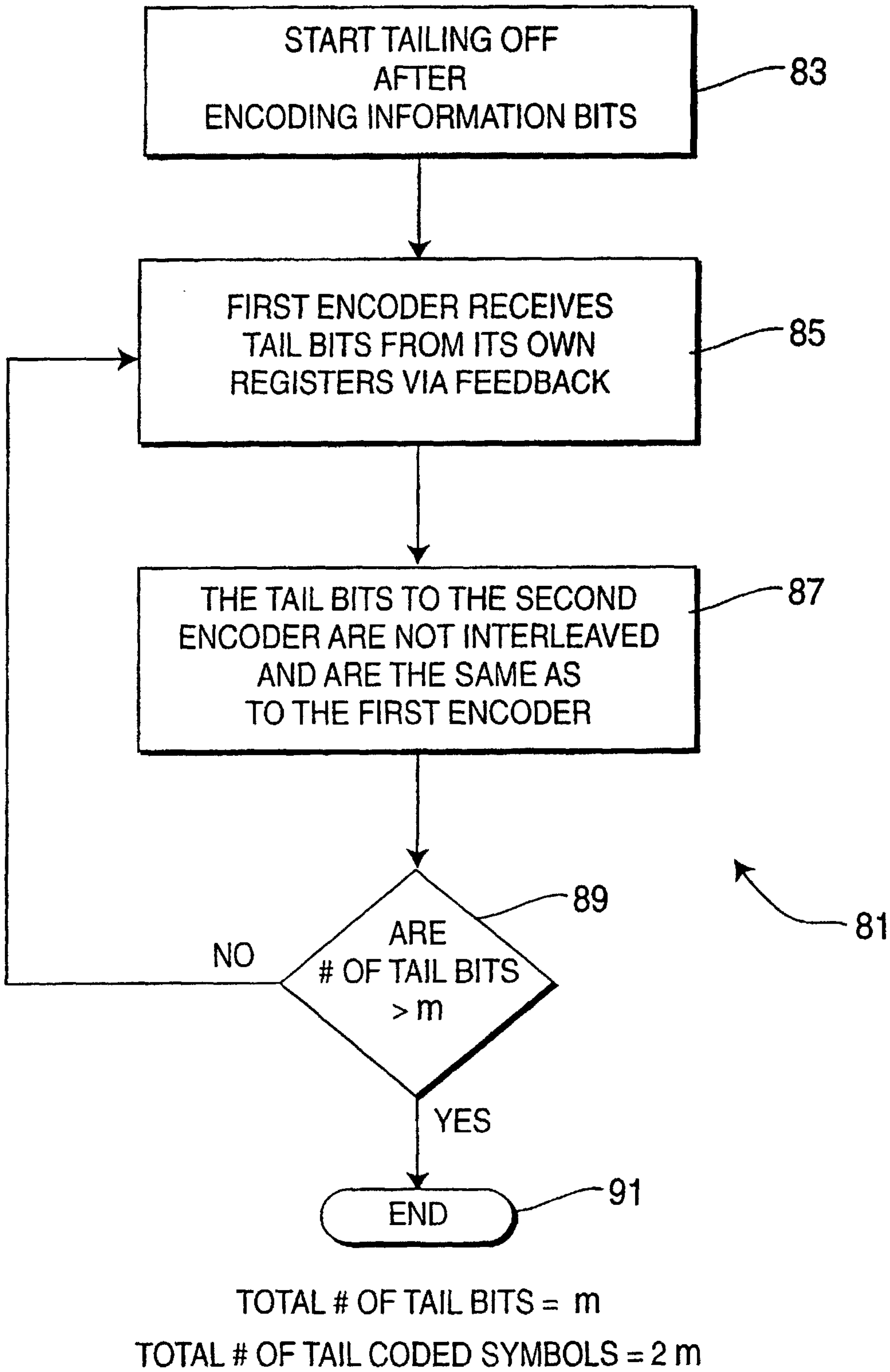
START TAILING OFF
AFTER
ENCODING INFORMATION BITS
83
FIRST ENCODER RECEIVES
TAIL BITS FROM ITS OWN
REGISTERS VIA FEEDBACK
85
THE TAIL BITS TO THE SECOND
ENCODER ARE NOT INTERLEAVED
AND ARE THE SAME AS
TO THE FIRST ENCODER
87
ARE
# OF TAIL BITS
> m
89
NO
YES
81
END
91
TOTAL # OF TAIL BITS = m
TOTAL # OF TAIL CODED SYMBOLS = 2 m

*FIG. 11*

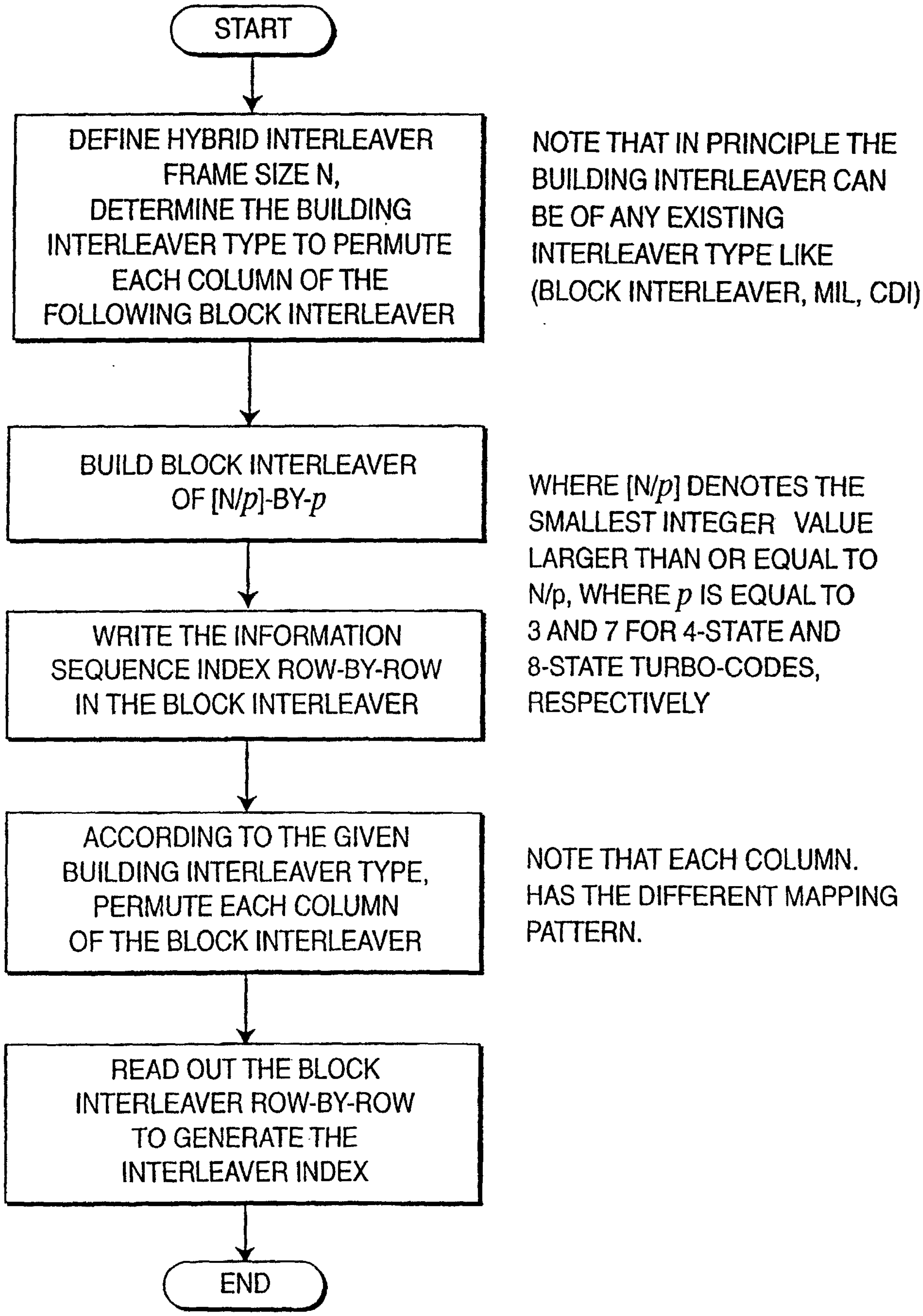
START
DEFINE HYBRID INTERLEAVER FRAME SIZE N, DETERMINE THE BUILDING INTERLEAVER TYPE TO PERMUTE EACH COLUMN OF THE FOLLOWING BLOCK INTERLEAVER
NOTE THAT IN PRINCIPLE THE BUILDING INTERLEAVER CAN BE OF ANY EXISTING INTERLEAVER TYPE LIKE (BLOCK INTERLEAVER, MIL, CDI)
BUILD BLOCK INTERLEAVER OF [N/p]-BY-p
WHERE [N/p] DENOTES THE SMALLEST INTEGER VALUE LARGER THAN OR EQUAL TO N/p, WHERE p IS EQUAL TO 3 AND 7 FOR 4-STATE AND 8-STATE TURBO-CODES, RESPECTIVELY
WRITE THE INFORMATION SEQUENCE INDEX ROW-BY-ROW IN THE BLOCK INTERLEAVER
ACCORDING TO THE GIVEN BUILDING INTERLEAVER TYPE, PERMUTE EACH COLUMN OF THE BLOCK INTERLEAVER
NOTE THAT EACH COLUMN. HAS THE DIFFERENT MAPPING PATTERN.
READ OUT THE BLOCK INTERLEAVER ROW-BY-ROW TO GENERATE THE INTERLEAVER INDEX
END

*FIG. 12*